# EUROPEAN PATENT APPLICATION

(11) **EP 2 194 764 A1**
(43) Date of publication of application: **09.06.2010**
(21) Application number: 08021042.0
(22) Date of filing: 04.12.2008
(51) Int. Cl.: H05K 3/10

(54) **Method for generation of electrically conducting surface structures, apparatus therefor and use**

(71) Applicant: Stichting Dutch Polymer Institute, 5612 AB Eindhoven (NL); Nederlandse Organisatie voor Toegepast- Natuurwetenschappelijk Onderzoek TNO, 2628 VK Delft (NL)
(72) Inventor: The designation of the inventor has not yet been filed
(74) Representative: Ackermann, Joachim

(57) **Abstract**

Method for generation of electrically conducting surface structures, apparatus therefor and use

Disclosed is a method for generating conductive surface patterns on a substrate by coating the substrate with a predetermined pattern of electrically conductive particles or of particles of a material that can be converted by heating into an electrically conducting material, and sintering or melting the coated substrate by means of electromagnetic radiation and by applying an antenna for said electromagnetic radiation in the vicinity of the predetermined pattern.

The process is easy to implement, needs only low energy, is very fast and can be used to generate electrically conductive patterns at low cost.

## Description

### Disclosure

This invention relates to the manufacture of electrically conducting surface patterns by a simple and efficient method, to an apparatus adapted to carry out this method and to the use of an antenna to improve the sintering efficiency provided by electromagnetic radiation.

Printing techniques, such as ink-jet printing, are interesting alternatives for the production of electronic and other structures. Printing has the advantage of low cost, ease of processing, potential for mass production and flexibility. A typical application is ink-jet printing of conductive tracks. Some different strategies were adopted to print such structures. In the scientific literature, the use of inks based on an (in)organic silver or copper precursor is described (A. L. Dearden et al. in Macromol. Rapid Commun. 2005, 26, 315-8 or Z. Liu et al. in Thin Solid Films 2005, 478, 275-9 or J. B. Szczech et al. in IEEE Trans. on Electronics Packaging Manuf., 2002, 25, 26-33 or C. M. Hong et al. in IEEE Electron Device Letters, 2000, 21, 384-6 or T. Cuk et al. in Appl. Phys. Lett. 2000, 77, 2063-5).

The printed structures need a sintering step to become conductive. The use of nanoparticles reduces the sintering temperature due to the high surface-to-volume ratio, as disclosed in WO-A-2004/005,413.

Different techniques to sinter printed nanoparticle structures have been disclosed.

One of these methods is the use of conventional radiation-conduction-convection heating. To obtain sufficient conductivity temperatures required are typically above 200° C, whereas the sintering times are typically 60 minutes or more. The long sintering times required imply that the technique is not feasible for fast industrial production. Kan-sen Chou et al. in Nanotechnology 16 (2005) 779-784 disclose the fabrication and sintering effect on the morphologies and conductivity of nano AG-particle films by the spin coating method. The authors have observed that the sintering behaviour depends on the size of the nanoparticles and that the conductivity of the sintered tracks depends on the sintering temperature.

In WO-A-2007/039227 the use of microwaves for sintering printed metal nanoparticles has been disclosed. This method allows the industrial production of metallic surface patterns at high speed while using a printing technology to create the surface patterns.

US 2006/0219715 A1 discloses a method of curing of imprinted material using RF and/or microwave radiation in addition to thermal energy. Different imprinted materials are disclosed, for example imprinted organic materials, polymers or metals. In one embodiment of this method a susceptor located externally, adjacent to or combined with the imprinted material is used. This susceptor absorbs RF and/or microwave frequency energy and responsive thereto emits thermal energy towards the imprinted material to aid in curing the imprinted material. As an example for a susceptor material carbon black is mentioned. Thus this document discloses the use of a material that absorbs RF or microwave radiation and that transmits the energy of said radiation into heat.

While microwave sintering has been reported as a fast and selective technique for sintering printed structures of metal nanoparticles this process still needs some time to be accomplished. Typically about three minutes are necessary to render inkjet printed features conductive, instead of 60 minutes with thermal sintering. However, a relatively high power of about 300 W is necessary for this. Depending on the substrate of the printed structures most of the energy during microwave exposure can be dissipated as heat to the substrate. Thus the substrate temperature increases and if polymer foils with a relatively low softening temperature are used the substrate could deform during the process.

Surprisingly it has now been found that the efficiency of the transfer of radiation energy from the generator to the imprinted nanoparticles can be improved if an antenna for said radiation is positioned on the imprinted structures and/or close to the imprinted structures to be cured by said radiation.

It is an objective of the present invention to provide an improved fast, simple and cost-efficient technique that allows formation of conductive surface patterns by sintering or melting of printed structures.

The present invention relates to a process for generating electrically conducting surface patterns on a substrate surface comprising the steps:
i) coating a surface of a substrate with a predetermined pattern of particles of electrically conducting material or of particles of a material that can be converted by heating into an electrically conducting material by applying said particles onto said surface,
ii) positioning at least one antenna for electromagnetic radiation in the vicinity of said predeterminded pattern, and
iii) sintering or melting said particles on said surface by means of electromagnetic radiation to form electrically conductive patterns on said surface,
wherein steps i) and ii) can be applied in either order.

The process of this invention uses at least one antenna structure which is positioned in the vicinity of the printed structures comprising nanoparticles to be sintered or melted. Upon exposure of the electromagnetic radiation to the imprinted device the antenna will capture electromagnetic waves more efficient than the particles or the substrate. The electromagnetic energy will then be transported from the antenna to the particles and/or to the substrate in a very efficient manner whereby heat is generated throughout the imprinted structures thus causing the particles to sinter or to melt more efficiently as without the antenna.

In the process of this invention generally each substrate can be used as long as this absorbs microwave radiation to a smaller extent as the particles applied to the surface of said substrate. The selection of substrate and metal is performed to result in a lower dielectric loss factor e" of the material forming the substrate as compared to the dielectric loss factor e" of the metal forming the surface pattern. In general the dielectric loss factor e" of the substrate is lower than 50 %, preferably lower than 10 % of the dielectric loss factor e" of the metal forming the surface pattern. This causes the microwaves to couple predominantly with the material with the highest dielectric loss factor, resulting in selective heating of the printed structure, which in turn results in an improvement of desirable properties, such as conductivity or mechanical strength.

More particularly, the substrate should absorb microwave radiation to a lesser extent than the material that constitutes the printed structure and that constitutes the antennae, i.e. within the frequency range of interest the dielectric loss factor e" of the material that constitutes the printed structure and that constitutes the antennae should be considerably higher than the dielectric loss factor e" of the substrate material.

A large variety of substrates can be chosen for the method of this invention. Non limiting examples are polymers (thermoplastic and duroplastic polymers including elastomers); inorganic materials, such as ceramic materials; semi-conducting substrates, such as silicon or gallium-arsenide, fibrous substrates containing natural and/or man-made fibers, such as paper, textile sheets including non-wovens; film and sheet materials made from polymers and or natural materials, such as leather, wood or thermoplastic sheet or bulk materials including composites containing said sheet or bulk materials.

Suitable substrates can possess a large variety of properties. For example, they can be transparent or non-transparent, or they can be crystalline or non-crystalline or they can contain adjuvants, such as pigments, antistatic agents, fillers, reinforcing materials, lubricants, processing aids and heat and/or light stabilizers.

Preferred substrates are thermoplastic polymers, such as polyesters (e.g. polyethyleneterephthalate), polyamides, polyimides, polyether-imides, polycarbonates, polyolefins (e.g. polyethylene or polypropylene), polyetherketones, polysiloxanes and polyarylenesulphides, such as polyphenylenesulphide.

As material forming the surface pattern in general each electrically conducting material or each material that can be converted by heating into an electrically conducting material can be used. Examples of materials which may be used for forming the surface pattern are metals, metal alloys, electrically conductive metal compounds, such as electrically conductive metal oxides or metal sulfides, electrically conducting polymers, or metal salts or metal complexes that can be readily converted into zerovalent metals during the drying and/or sintering process.

Examples of metals are noble metals, such as gold and/or silver, or metals from the groups 9, 10 and 11 of the periodic system of the elements, very preferred Co-, Ni- and Cu.

An example for an electrically conductive metal oxide is indium tin oxide.

Examples of electrically conductive polymers are poly-(3,4-ethylenedioxythiophene) (PEDOT) or polyaninline (PANI).

Preferably gold and especially preferred silver or alloys containing silver and other metals are used. Mixtures of different metals can also be used.

The electrically conductive materials or the precursors of electrically conductive materials are applied in the form of particles to the surface. The particle form helps to develop predetermined surface patterns. In addition it has been found that with smaller particle diameters and thus larger surface to volume ratios of the particles the heat generation and development of conductive patterns is promoted.

Typical mean particle diameters are in a range between 1 nm and 100um, preferably 1 nm - 1 µm, very preferred 1 nm - 100 nm and especially preferred 1 nm - 50 nm. The mean particle diameter is determined by transmission electron microscope (TEM).

Very preferably metal nanoparticles are used, which allow the formation of conducting surface patterns with minimum amount of electromagnetic energy.

The structures forming the antenna are not particularly limited. These structures must be capable to absorb electromagnetic energy and to transmit this to the electroconductive particles positioned in the vicinity of said antenna. The term "in the vicinity of" as used in this specification shall mean that the antenna and the imprinted structure to be melted or sintered are positioned in a distance from each other that will be sufficient to result in an improved heating of the imprinted structure. The antenna may be in direct contact with the imprinted structure or the distance between the antenna and the imprinted structure may be less than about 10 centimeters, preferably less than about 5 centimeters.

The antenna can be deposited on the surface of the substrate in the proximity of the imprinted structures to be sintered or melted. In an alternative embodiment or in addition to this the antenna can be positioned above or below or laterally to the surface of the substrate in the proximity of the imprinted structures. In still another alternative embodiment or in addition to this the antenna can be positioned in direct contact above or below the imprinted structures. The distance between the antenna and the imprinted structures to be sintered can be varied. Typically a distance between some millimeters and some centimeters will be sufficient to result in an improved heating of the imprinted structures. Besides this there can be contact between the antenna and the imprinted structures to be sintered or melted. The skilled artisan can vary this distance to obtain optimum results by using routine experiments.

The antenna forms a body of electroconductive material or a body of ferromagnetic material. All materials showing these properties can be used.

Examples of electroconductive materials are as defined for the electroconductive particles. Thus as a material forming the anntenna in general each electrically conducting material can be used, for example metals, metal alloys, electrically conductive metal compounds, such as electrically conductive metal oxides or metal sulfides, and electrically conducting polymers.

Examples of ferromagnetic materials are iron, cobalt, nickel, lanthanides or ferromagnetic alloys comprising iron, cobalt and/or nickel as a component.

In one embodiment of the process of this invention the antenna is deposited as an electrically conductive pattern or as a ferromagnetic pattern onto the substrate in the proximity of the printed structures to be sintered or to be melted. Several antennae can be used, preferably if a variety of different printed structures are available.
In another embodiment of the process of this invention the antenna is deposited as an electrically conductive pattern or as a ferromagnetic pattern onto the substrate in contact with the printed structures to be sintered or to be melted. Several antennae can be used, preferably if a variety of different printed structures are available.

The antenna can be applied by any known dispensing technique onto the substrate.

Examples thereof are sputtering or evaporating of patterns onto the surface of the substrate, printing of patterns onto the surface of the substrate, spraying of patterns via a mask onto the surface of the substrate, or applying pastes, suspensions or emulsions by printing methods, by pipetting or by other methods onto the surface of the substrate.

The form of the antenna is not limited. Examples are stripes, lines, circles or dots. Instead of using a sheet-like antenna, which is preferably applied onto the substrate, bulk-like bodies can be used. Examples thereof are wires, rods or plates. Bulk-like bodies can be placed in contact with the surface of the substrate or preferably above the surface on or below or in the vicinity of the printed structures to be sintered or to be melted. Preferably an antenna in the form or one or more wires or rods is placed in contact with or directly above the imprinted structure to be sintered or to be melted.

Upon exposure of electromagnetic radiation, like radio-frequency waves, the antenna will capture this much more efficient than the imprinted structures containing electrically conducting particles. Per unit square the absorption of energy is much larger within the presence of the antenna. The electromagnetic energy will then be transported from the conductive or ferromagnetic antenna to the non- or lower-conducting imprinted structures, whereby heat is generated very efficiently throughout said structures. Antenna structures absorb electromagnetic waves with a specific wavelength as the most efficient one, depending on the antenna characteristics, like its length. Therefore, the length of the antenna and the frequency of the radiation, such as the radio-frequency radiation, can be optimised in terms of absorption.

Conductivity values between 10 and 34 % of bulk silver have been revealed by exposing only for 1 second and 1 W of power of microwave energy having a frequency of 2.54 GHz. These values are considerably higher than conventional radiation-conduction-convection heating, where values around 5 % were obtained.

The electromagnetic radiation to be used in the process of the present invention must be capable to create heat in the electrically conductive particles or in the particles of the precursor material of the imprinted structures to cause said particles to sinter or to melt to create electrically conductive structures. The nature of electromagnetic radiation will vary from case to case and may be selected depending on the nature of the material forming the particles to be heated.

Non-limiting examples of electromagnetic radiation are radio-frequency waves, infrared waves, radiation in the visible or in the ultraviolett range and X-rays or combinations of different types of radiation.

Preferably radio-frequency waves, very preferred microwaves are used. Metal particles absorb microwave radiation, i.e. electromagnetic radiation with wavelengths ranging from 1 mm to 1 m in free space corresponding to a frequency between approximately 300 GHz to 300 MHz, respectively.

The surface of the substrate may be coated with electrically conductive particles by applying a dispersion containing said particles in a liquid onto said surface.

The coating of the substrate with a predeterminded pattern of electrically conductive particles or of particles of a material that can be converted by heating into an electrically conducting material can be performed prior to or after the formation of the antenna(e) structure(s)

Different dispensing methods can be used as long as these allow the coating of a surface by creation of a predetermined surface pattern. Predetermined surface patterns can be layers covering the whole surface or other forms of surface coverage. Preferably surface patterns cover portions of the surface, for example in the form of tracks and/or of isolated spots of metal particles. Several surfaces of the substrate can be coated. For example two surfaces of a sheet material can be coated in the form of tracks which are optionally connected via holes going through the substrate and containing conductive material.

Examples of dispensing methods are known in the art of applying surface coatings, such as curtain coating, spin-coating or coating by means of doctor blade.

Preferably printing methods are used, such as ink-jet printing, offset printing, gravure printing, flexo printing, screen printing, spray coating, dip coating and aerosol coating.

Initially, the coating material that forms the patterns on said surface(s) is present as a dispersion of the particles in a carrier material that renders the coating material pasty or preferably fluid. The pasty coating material is hereafter referred to as "paste". The fluid coating material is hereafter referred to as "ink".

The paste or ink is applied to the surface of the substrate to form a pattern after drying by means of a printing technique or by a pipetting technique, for example by ink-jet printing.

When applying the paste or ink to the surface of the substrate the carrier material can be removed at the same time, for example by heating the substrate and by chosing a carrier material that evaporates or decomposes at the substrate temperature. In an alternative or an additional step the carrier material can be evaporated or decomposed after the formation of the surface pattern in a separate heat treatment step or the carrier material can be evaporated or decomposed during the treatment with microwave radiation.

After a predetermined pattern of electrically conductive particles or of particles of a material that can be converted by heating into an electrically conducting material has been formed on the substrate surface(s) this is then exposed for a selected time to electromagnetic radiation of selected power.

If metal particles and microwaves are used, the microwaves couple predominantly with the metal particles forming the material with the highest dielectric loss factor e". This results in selective heating of the printed structure. Most of the heat generated by absorption of the microwave radiation develops in the metal particles and causes these to melt and/or to sinter, which in turn results in an improvement of desirable properties, such as conductivity or mechanical strength. It is believed that the conductive particle interaction with microwave radiation, i.e. inductive coupling, is mainly based on Maxwell-Wagner polarization, which results from the accumulation of charge at the materials interfaces, electric conduction, and eddy currents. The particles subsequently have an induced internal electrical field and the electrical charge dissipates as heat into the particles.

The equipment for performing the method of this invention can be chosen from known devices. Coating devices, heat treatment devices, antennae and electromagnetic radiation generators, such as microwave generators, are known in the art and commercially available.

But the combination of these devices has not been used yet and is also subject of this invention.

The processed substrates containing conductive surface patterns can be compiled to form a layered product with several substrates possessing conductive patterns in the interior and on the surface. The layered products can contain layers of other materials besides the processed substrates containing conductive surface patterns of metal.

The invention also relates to a device for performing the above-defined method comprising the combination of
A) a coating device for surface coating of a substrate with a predetermined pattern of electrically conducting particles or of particles of a material that can be converted by heating into an electrically conducting material,
B) at least one antenna for electromagnetic radiation positioned in the vicinity of said predeterminded pattern, and
C) an electromagnetic radiation generator to generate conductive patterns by sintering or melting the patterns of particles on the surface of said substrate.

Preferably the coating device is a printing device.

In another preferred device of the invention the antenna is an electrically conducting or a ferromagnetic sheet, wire or rod and said antenna is positioned in contact with or above the surface carrying the predetermined pattern of particles.

Furthermore, the invention relates to the use of an antenna to improve the sintering or melting by electromagnetic radiation of a predetermined pattern of electrically conductive particles or of particles of a material that can be converted by heating into an electrically conducting material on a substrate.

The process for generating electrically conductive surface patterns on a substrate surface can be used, for example, for the production of printed wiring boards, of integrated circuits, of decorative sheets, of data recording or of data storing media, print boards, of radio frequency identification tags (RFID tags), of organic light emitting devices (OLED), of thin-film transistors (TFT), of electrical devices, like heating elements, resistors, coils or antennae, of displays, of smart packages, of flexible circuits, of sensors or of photovoltaic devices.

These uses are also subject of the present invention.

The following Examples illustrate the invention without any limitation.

### Example 1

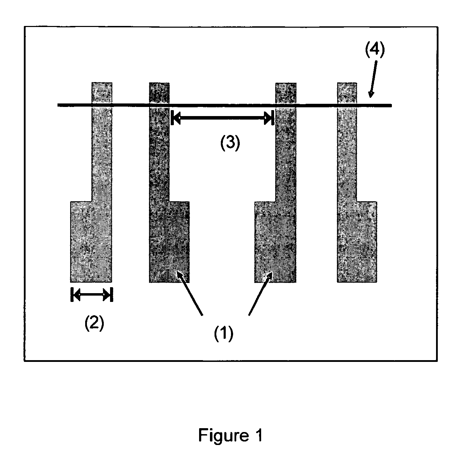

The antenna structures were fabricated by inkjet printing of a colloidal dispersion of silver nanoparticles onto a flexible polyethylene naphthalate (PEN) foil. The template consisted of four metal areas, each having a surface area of 11 mm². The printed structures is shown in Figure 1. Four antennae (1) with lower width (2) of 2 mm were prepared. The upper portions (3) of the inner two anntennae are spaced apart 5 mm. Above the upper portions of the antennae (3) a single line (4) of silver nanoparticles was imprinted.

After imprinting of the antennae (1) subsequently curing of these antennae templates was performed at 110°C for 60 minutes. These antennae (1) were used both to measure the resistance of the single ink line (4) and to capture electromagnetic waves, which was possible since the electrodes were composed of particles that are able to absorb microwaves. After formation of the antennae (1), a single silver ink line (4) was printed over the metallic probes and shortly cured in an oven for 1 to 5 minutes at a temperature of 110 °C. This relatively short time was chosen to stimulate solvent evaporation, but to minimize thermal curing. After this treatment, the single line (4) had a relatively high resistance in the order of 10² to 10⁴ Ω. The sample was then exposed to microwave radiation for at least 1 second, while applying the lowest set-power of 1 W. This resulted in a pronounced decrease of the resistance to a value of 1-4 Ohm/cm.

### Example 2

In this Example a similar structure was formed as in Example 1 with the exception that line (4) was not placed into contact with antennae (1) but was positioned in the free space between the upper portions (3) of the inner two anntennae. If the gaps between the ends of line (4) and the upper portions (3) were about 1 mm the resistance of the sintered line (4) after exposure to microwave radiation for about 1 second and a power of 1 W was about 6 Ohms/cm.

When using the experimental set-up of Example 2 a gap of 1-10 mm was be present between the antennae and the line, without resulting in non-sintering. When using these gaps the sintering still took place efficiently and the resistance decreased to 6 - 265 Ohm/cm, depending on the gap distance.

## Claims

1. A process for generating electrically conducting surface patterns on a substrate surface comprising the steps:
i) coating a surface of a substrate with a predetermined pattern of particles of electrically conducting material or of particles of a material that can be converted by heating into an electrically conducting material by applying said particles onto said surface,
ii) positioning at least one antenna for electromagnetic radiation in the vicinity of said predeterminded pattern, and
iii) sintering or melting said particles on said surface by means of electromagnetic radiation to form electrically conductive patterns on said surface,
wherein steps i) and ii) can be applied in either order.

2. A process as claimed in claim 1, wherein the surface of the substrate is coated with with a predetermined pattern of metal particles and/or by particles of an electrically conducting metal oxide, preferably by applying a dispersion containing said metal particles and/or containing said electrically conducting metal oxide particles in a liquid onto said surface, and optionally drying said coated substrate to cause said liquid to evaporate

3. A process as claimed in claim 1, wherein the metal is gold, silver or a combination thereof, preferably silver.

4. A process as claimed in any of the claims 1 to 3, wherein the metal particles possess a mean particle diameter between 1 nm and 100 µm, especially preferred between 1 nm and 50 nm.

5. A process as claimed in any of the claims 1 to 4, wherein as a coating method a printing method is used.

6. A process as claimed in any of the claims 1 to 5, wherein the antenna for electromagnetic radiation is a body of electrically conducing material or of ferromagnetic material, which is in contact with the surface of the substrate containing the predetermined pattern of the particles.

7. A process as claimed in any of the claims 1 to 5, wherein the antenna for electromagnetic radiation is a body of electrically conducting material or of ferromagnetic material, which is positioned above the surface of the substrate containing the predetermined pattern of the particles.

8. A process as claimed in any of the claims 6 or 7, wherein the electrically conducting material is a metal, an electrically conducting polymer or an electrically conducting metal oxide.

9. A process as claimed in any of the claims 6 or 7, wherein the ferromagnetic material is selected from iron, cobalt, nickel, a lanthanide or a ferromagnetic alloy comprising iron, cobalt and/or nickel as a component.

10. A process as claimed in any of the claims 1 to 9, wherein the electromagnetic radiation is radio-frequency radiation, preferably microwave radiation.

11. A device for performing the method according to claim 1 comprising the combination of
A) a coating device for surface coating of a substrate with a predetermined pattern of electrically conducting particles or of particles of a material that can be converted by heating into an electrically conducting material,
B) at least one antenna for electromagnetic radiation positioned in the vicinity of said predeterminded pattern, and
C) an electromagnetic radiation generator to generate conductive patterns by heating the patterns of particles on the surface of said substrate.

12. A device according to claim 11, wherein the coating device is a printing device.

13. A device according to claim 11, wherein the antenna is an electrically conducting or a ferromagnetic sheet, wire or rod which is positioned in contact with or above the surface carrying the predetermined pattern of particles.

14. A device according to claim 11, wherein the electromagnetic radiation generator is a microwave generator.

15. Use of an antenna to improve the sintering or melting by electromagnetic radiation of a predetermined pattern of electrically conductive particles or of particles of a material that can be converted by heating into an electrically conducting material, on a substrate.

16. Use of the process according to any of the claims 1 to 10 for the production of printed wiring boards, of integrated circuits, of decorative sheets, of data recording or of data storing media, of print boards, of radio frequency identification tags, of organic light emitting devices, of thin-film transistors, of electrical devices, of displays, of smart packages, of flexible circuits, of sensors or of photovoltaic devices.
